# FASCICULE DE BREVET EUROPEEN

(11) **EP 2 711 722 B1**
(45) Date de publication et mention de la délivrance du brevet: **25.05.2022**
(21) Numéro de dépôt: 13185014.1
(22) Date de dépôt: 18.09.2013
(51) Int. Cl.: G01R 19/00, G01R 19/165

(54) **Circuit de mesure de tension différentielle**
Schaltkreis zum Messen der Differentialspannung
Circuit for measuring differential voltage

(30) Priorité: 19.09.2012 FR 1258787
(43) Date de publication de la demande: 26.03.2014
(73) Titulaire: COMMISSARIAT À L'ÉNERGIE ATOMIQUE ET AUX ÉNERGIES ALTERNATIVES, 75015 Paris (FR)
(72) Inventeur: Despesse, Ghislain, 38120 Saint Egreve (FR); Lechat Sanjuan, Sylvain, 34070 Montpelllier (FR)
(74) Mandataire: Cabinet Beaumont

(56) Documents cités:
- EP-A1- 0 443 239
- WO-A1-2009/020566
- JP-A- H09 321 551
- US-A- 6 091 226
- US-A1- 2006 220 743
- US-A1- 2006 250 166
- US-A1- 2010 173 183
- Marston Ray: "BIPOLAR TRANSISTOR COOKBOOK - PART 8", , 1 February 2004 (2004-02-01), XP055742643, Retrieved from the Internet: URL:http://nutsvolts.texterity.com/nutsvol ts/200402//Print_submit.action?articleTitl e=&articlePrintMode=false&start=70&end=71& prettyPrint=false&lm=1505419430000 [retrieved on 2020-10-21]
- C Leach ET AL: "Current Mirrors Basic BJT Current Mirror", , 1 January 2008 (2008-01-01), XP055746498, Retrieved from the Internet: URL:https://leachlegacy.ece.gatech.edu/ece 3050/notes/bjt/bjtmirr.pdf [retrieved on 2020-11-03]

## Description

### Domaine de l'invention

La présente invention concerne un circuit de mesure de tension différentielle. Elle vise notamment l'utilisation d'un tel circuit pour mesurer la tension fournie par une cellule génératrice de tension dans un système électrique comprenant une pluralité de cellules génératrices reliées en série, par exemple une batterie électrique.

### Exposé de l'art antérieur

Une batterie électrique est un groupement de plusieurs cellules élémentaires (piles, accumulateurs, etc.) reliées en série entre deux noeuds ou bornes de fourniture d'une tension continue. Dans certaines applications, par exemple dans le domaine des batteries pour véhicules électriques, des circuits sont prévus pour mesurer et contrôler la tension de cellules élémentaires. Des circuits de mesure connus utilisent des amplificateurs différentiels. Toutefois, tout au long de la chaîne, les cellules ont des tensions de mode commun de plus en plus élevées, il est donc nécessaire d'utiliser des amplificateurs différentiels alimentés par une tension supérieure ou égale à la pleine tension de la batterie. Ceci n'est pas toujours possible, et, quand ça l'est, entraîne une consommation d'énergie relativement importante par les circuits de mesure, et augmente le prix de revient de la batterie. Une autre solution consiste, pour les cellules ayant une tension de mode commun élevée, à ramener les potentiels haut et bas de la cellule à des valeurs plus faibles au moyen d'une paire de résistances de même valeur, ou d'une paire de ponts diviseurs de même rapport de division, et d'effectuer la mesure de tension différentielle en aval des résistances. Ceci permet d'utiliser des circuits de mesure alimentés par une tension inférieure à la pleine tension de la batterie, mais présente l'inconvénient de diminuer sensiblement la précision de la mesure, notamment en raison des marges d'erreur qui existent sur les valeurs des résistances (la perte de précision étant d'autant plus importante que le rapport de division est élevé). Par ailleurs, dans les cartes de gestion de batterie connues, il existe des risques de dégradation et/ou électrocution liés au fait que des bornes d'entrées reçoivent directement la tension des cellules de la batterie.

Un exemple de circuit de mesure de tension différentielle est décrit dans le document WO2009/020566. Le document US2006/0250166 décrit un autre exemple de circuit de mesure de tension différentielle. Le document US6091226 décrit un exemple de circuit de comparaison d'une tension à un seuil. Le document US2010/0173183 décrit des systèmes et méthodes de détection d'anomalie de cellule de batterie.

### Résumé

L'invention a pour objet un circuit de mesure de tension différentielle selon la revendication 1. D'autres caractéristiques avantageuses dudit circuit de mesure selon l'invention sont définies dans les revendications dépendantes.

### Brève description des dessins

Des exemples et des modes de réalisation du circuit de mesure de tension différentielle, ainsi que leurs caractéristiques et avantages, seront exposés en détail dans la description suivante de modes de réalisation particuliers faite à titre non limitatif en relation avec les figures jointes parmi lesquelles :
la figure 1 est un schéma électrique représentant un exemple de réalisation, ne formant pas partie de l'invention revendiquée, d'un circuit de mesure de tension différentielle ;
la figure 2A est un schéma électrique partiel illustrant un exemple de réalisation, ne formant pas partie de l'invention revendiquée, d'un circuit de mesure de tension différentielle ; les figures 2B à 2C sont des schémas électriques partiels illustrant des modes de réalisation selon l'invention revendiquée, du circuit de mesure de tension différentielle ;
la figure 3 est un schéma électrique représentant un mode de réalisation selon l'invention revendiquée, d'un circuit de mesure de tension différentielle ;
la figure 4 est un schéma électrique représentant un exemple de réalisation, ne formant pas partie de l'invention revendiquée, d'un circuit de mesure de tension différentielle apte à fonctionner quel que soit le signe de la tension appliquée à ses bornes ;
les figures 5A et 5B sont des schémas électriques partiels illustrant des exemples de réalisation, ne formant pas partie de l'invention revendiquée, d'un circuit de mesure de tension différentielle apte à fonctionner lorsqu'une tension différentielle de mode commun négatif est appliquée à ses bornes ;
la figure 6 est un schéma électrique représentant un exemple de réalisation, ne formant pas partie de l'invention revendiquée, d'un circuit de mesure de tension différentielle apte à fonctionner quel que soit le signe du mode commun de la tension à mesurer ;
la figure 7 est un schéma électrique représentant un exemple de réalisation, ne formant pas partie de l'invention revendiquée, d'un circuit de mesure de tension différentielle apte à fonctionner quel que soit le signe du mode commun de la tension à mesurer ;
la figure 8 est un schéma électrique représentant un exemple de réalisation, ne formant pas partie de l'invention revendiquée, d'un circuit de mesure de tension différentielle apte à fonctionner quel que soit le signe de la tension appliquée à ses bornes et quel que soit le signe du mode commun de cette tension ;
les figures 9, 10 et 12 sont des schémas électriques partiels illustrant des modes de réalisation selon l'invention revendiquée, du circuit de mesure de tension différentielle ; la figure 11 est un schéma électrique partiel illustrant un exemple de réalisation, ne formant pas partie de l'invention revendiquée, d'un circuit de mesure de tension différentielle ;
la figure 13 est un schéma électrique illustrant un exemple d'utilisation, ne formant pas partie de l'invention revendiquée, d'un circuit de mesure de tension différentielle dans une batterie électrique ; et
la figure 14 est un schéma électrique illustrant un autre exemple d'utilisation, ne formant pas partie de l'invention revendiquée, d'un circuit de mesure de tension différentielle dans une batterie électrique.

Par souci de clarté, de mêmes éléments ont été désignés par de mêmes références aux différentes figures. De plus, seuls les éléments utiles à la compréhension de l'invention ont été représentés et décrits.

### Description détaillée

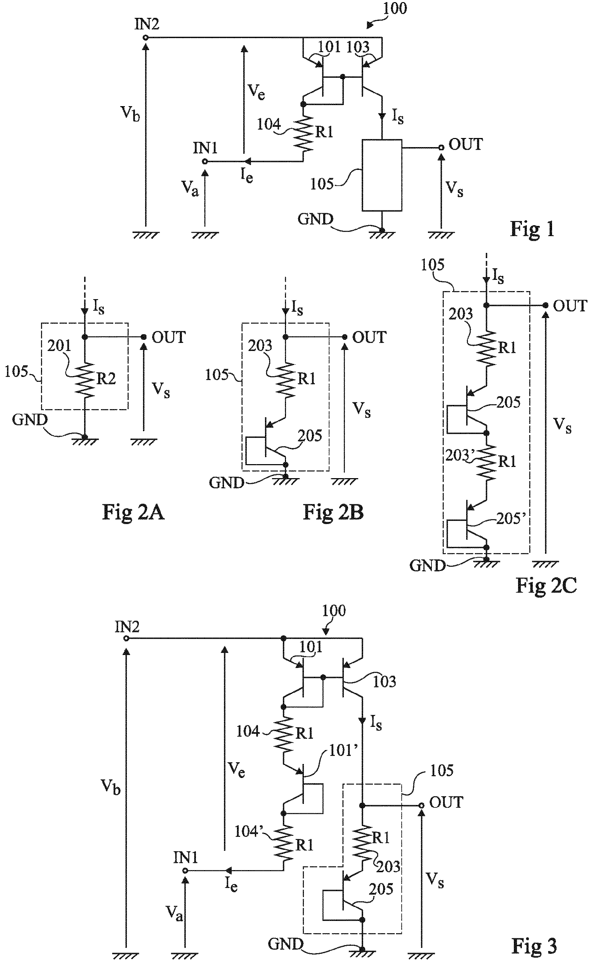

La figure 1 est un schéma électrique représentant un exemple de réalisation d'un circuit de mesure de tension différentielle. Le circuit de la figure 1 comprend un miroir de courant 100 dont la branche d'entrée comprend un transistor bipolaire 101 monté en diode (base et collecteur reliés), et dont la branche de sortie comprend un transistor bipolaire 103 dont la base est reliée à la base du transistor 101. Dans l'exemple représenté, les transistors 101 et 103 sont des transistors PNP. Les émetteurs des transistors 101 et 103 sont reliés à un noeud IN2 d'application du potentiel haut V_{b} d'une tension différentielle Vₑ à mesurer. Le collecteur du transistor 101 est relié à un noeud IN1 d'application du potentiel bas Vₐ de la tension Vₑ (Vₑ = V_{b} - Vₐ) par l'intermédiaire d'un élément résistif 104 de valeur R1. Le collecteur du transistor 103 est relié à un noeud GND d'application d'un potentiel de référence, par exemple la masse, éventuellement par l'intermédiaire d'un élément de conversion courant/tension 105.

Lorsqu'une tension Vₑ positive (V_{b} > Vₐ) est appliquée entre les bornes IN1 et IN2, il circule, dans la branche d'entrée du miroir 100, un courant Iₑ proportionnel à Vₑ moins la tension de seuil du transistor 101 et, dans la branche de sortie du miroir 100, un courant Iₛ égal au courant Iₑ. Le courant Iₛ est représentatif de la tension différentielle d'entrée. Il peut être mesuré par des circuits (non représentés) alimentés par une tension inférieure au potentiel haut V_{b} de la tension différentielle Vₑ. La résistance 104 permet d'ajuster la relation entre le courant Iₛ et la tension différentielle Vₑ. Le courant Iₛ peut soit être numérisé directement au moyen d'un convertisseur analogique-numérique (non représenté), soit être transformé, par le convertisseur 105, en une tension Vₛ, image de la tension Vₑ mais ayant son potentiel bas ramené à la masse, fournie entre le noeud de référence GND et un noeud de sortie OUT du convertisseur 105.

Les utilisations qui peuvent être faites du courant Iₛ ou de la tension Vₛ (numérisation, utilisation pour commander un circuit de contrôle de cellules d'une batterie, etc.) ne seront pas décrites de façon exhaustive, les modes de réalisation proposés étant compatibles avec les utilisations habituelles des circuits de mesure différentielle.

Un avantage du circuit de la figure 1 est qu'il est plus simple à réaliser et moins coûteux que les circuits de mesure différentielle existants. Ce circuit permet en effet, dans sa version la plus simple, d'effectuer une mesure différentielle au moyen d'un unique miroir de courant (deux transistors 101 et 103) et de deux résistances (R1 et R2). De plus, dans le cas d'une utilisation pour mesurer la tension fournie par une cellule d'une batterie électrique, ce circuit ne nécessite ni une alimentation par la pleine tension de la batterie, ni un abaissement des potentiels haut et bas de la tension à mesurer au moyen d'une paire de ponts diviseurs de tension résistifs identiques. Par ailleurs, les risques de dégradation et/ou électrocution lors des manipulations sont réduits. Ceci permet aussi de protéger d'autres circuits susceptibles d'être référencés au même potentiel de masse GND que le circuit de mesure différentielle. Le circuit de la figure 1 est donc plus économe en énergie, plus précis, et plus sûr que les circuits existants.

Dans l'exemple de la figure 2A, le convertisseur 105 comprend un élément résistif 201 de valeur R2, par exemple une résistance, reliant le noeud OUT au noeud GND. Le noeud OUT est relié au collecteur du transistor 103. Le rapport R2/R1 fixe la relation entre la tension de sortie Vₛ et la tension d'entrée Vₑ moins la tension de seuil du transistor 101.

Dans le mode de réalisation de la figure 2B, le convertisseur 105 comprend, en série entre le noeud OUT et le noeud GND, une résistance 203 de même valeur R1 que la résistance 104 (figure 1), et un transistor 205 monté en diode, identique au transistor 101 (figure 1). Le noeud OUT est relié au collecteur du transistor 103. La résistance 203 est entre le noeud OUT et l'émetteur du transistor 205, et le collecteur du transistor 205 est relié au noeud GND. L'impédance du convertisseur courant/tension 105 (un transistor PNP monté en diode + une résistance de valeur R1) est ainsi identique à l'impédance d'entrée du circuit de mesure différentielle. Il en résulte que, dans la plage de fonctionnement du circuit de mesure, la tension de sortie Vₛ est égale à la tension d'entrée Vₑ.

Dans le mode de réalisation de la figure 2C, le convertisseur 105 comprend les mêmes éléments que dans l'exemple de la figure 2B, et comprend en outre, en série entre le collecteur du transistor 205 et le noeud GND, une résistance 203' identique à la résistance 203, et un transistor 205' monté en diode identique au transistor 205. La résistance 203' est entre le collecteur du transistor 205 et l'émetteur du transistor 205', et le collecteur du transistor 205 est relié au noeud GND. L'impédance du convertisseur courant/tension 105 est ainsi égale à deux fois l'impédance d'entrée du circuit de mesure différentielle. Il en résulte que, dans la plage de fonctionnement du circuit de mesure, la tension de sortie Vₛ est égale à deux fois la tension d'entrée Vₑ. On notera que dans cet exemple, les résistances 203 et 203' pourraient être remplacées par une unique résistance de valeur 2R1. De façon générale, il est toutefois avantageux d'utiliser des composants identiques dans la branche d'entrée du circuit de mesure et dans le circuit de conversion courant/tension 105, car cela permet notamment de garantir la symétrie des variations de comportement en fonction de la température dans les deux branches.

La figure 3 est un schéma électrique illustrant Z un mode de réalisation selon l'invention revendiquée, d'un circuit de mesure de tension différentielle. Le circuit de la figure 3 comprend les mêmes éléments que le circuit de la figure 1, et, dans l'exemple représenté, le convertisseur courant/tension 105 est le même que dans l'exemple de la figure 2B. Le circuit de la figure 3 comprend en outre, entre la résistance 104 et le noeud IN1 et en série avec le transistor 101 et la résistance 104, un transistor 101' monté en diode identique au transistor 101, et une résistance 104' identique à la résistance 104. L'émetteur du transistor 101' est relié à la résistance 104, et le collecteur du transistor 101' est relié au noeud IN1 par l'intermédiaire de la résistance 104'. L'impédance du convertisseur courant/tension 105 est ainsi égale à la moitié de l'impédance d'entrée du circuit de mesure différentielle. Il en résulte que, dans la plage de fonctionnement du circuit de mesure, la tension de sortie Vₛ est égale à la moitié de la tension d'entrée Vₑ.

L'homme du métier saura, en fonction de l'utilisation visée, prévoir d'autres rapports d'impédance entre l'entrée différentielle du circuit de mesure et l'élément de conversion courant/tension 105, de façon à obtenir d'autres relations, linéaires ou non-linéaires, entre la tension de sortie Vₛ et la tension d'entrée Vₑ.

Les circuits décrits en relation avec les figures 1 à 3 sont destinés à fonctionner lorsque la tension Vₑ = V_{b} - Vₐ à mesurer est positive (et supérieure à la tension de seuil du transistor 101). Dans certaines applications, par exemple lorsque la tension différentielle à mesurer est une tension alternative, ou lorsqu'on souhaite faciliter le montage du circuit de mesure en ne différentiant pas sa borne d'entrée haute de sa borne d'entrée basse, on ne connaît pas à l'avance le signe de la tension Vₑ à mesurer.

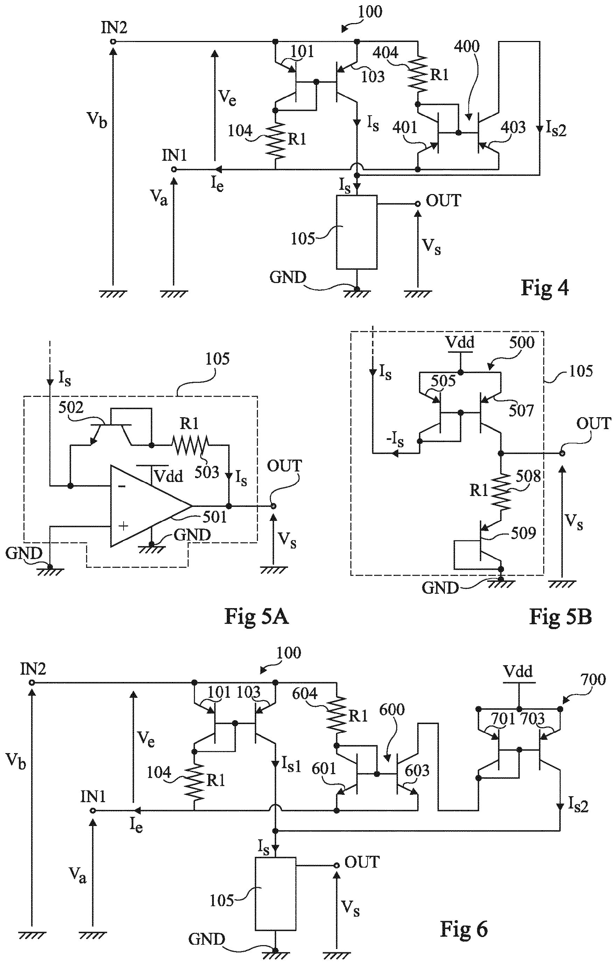

La figure 4 est un schéma électrique représentant un exemple de réalisation d'un circuit de mesure de tension différentielle apte à fonctionner quel que soit le signe de la tension Vₑ appliquée à ses bornes. Le circuit de la figure 4 comprend les mêmes éléments que le circuit de la figure 1, et comprend en outre, entre les noeuds d'entrée IN1 et IN2, un deuxième miroir de courant 400, identique au miroir 100 et une deuxième résistance d'entrée 404, identique à la résistance 104. Le miroir 400 et la résistance 404 sont connectés de la même façon que le miroir 100 et la résistance 104 mais en inversant les noeuds d'entrée IN1 et IN2. Le miroir 400 comprend, sur sa branche d'entrée, un transistor 401 monté en diode, identique au transistor 101, et sur sa branche de sortie, un transistor 403 identique au transistor 103, dont la base est reliée à la base du transistor 401. Les émetteurs des transistors 401 et 403 sont reliés au noeud d'entrée IN1. Le collecteur du transistor 401 est relié au noeud IN2 par l'intermédiaire de la résistance 404. Le collecteur du transistor 403 est relié au collecteur du transistor 103.

Lorsqu'une tension Vₑ positive (V_{b} > Vₐ) est appliquée entre les bornes IN1 et IN2, le transistor 401, polarisé en inverse, est bloqué. Le miroir de courant 400 est donc inactif. Un courant de sortie Iₛ positif, représentatif de la tension Vₑ, est généré par le miroir de courant 100 qui, lui, est actif. Lorsqu'une tension Vₑ négative (V_{b} < Vₐ) est appliquée entre les bornes IN1 et IN2, le transistor 101, polarisé en inverse, est bloqué. Le miroir de courant 100 est donc inactif. Un courant de sortie Iₛ positif, représentatif de la tension Vₐ - V_{b}, est généré par le miroir de courant 400 qui, lui, est actif. Ainsi, quel que soit le signe de la tension différentielle Vₑ appliquée en entrée, le circuit de la figure 4 fournit une grandeur Iₛ ou Vₛ représentative de la valeur absolue de Vₑ.

Les circuits décrits en relation avec les figures 1 à 4 sont destinés à fonctionner lorsque le mode commun V_{c} = (Vₐ + V_{b}) /2 de la tension Vₑ à mesurer est positif par rapport au potentiel du noeud GND (ou, plus généralement, lorsque le potentiel le plus haut de la tension Vₑ à mesurer est supérieur au potentiel du noeud GND d'une valeur au moins égale à la tension de saturation du transistor de sortie 103 ou 403 du miroir de courant).

Des circuits permettant de mesurer une tension Vₑ ayant un mode commun négatif peuvent être obtenus en remplaçant, dans les circuits décrits en relation avec les figures 1 à 4, les transistors bipolaires PNP par des transistors bipolaires NPN, sans changer les connexions d'émetteur, de base et de collecteur par rapport aux circuits des figures 1 à 4, mais en inversant les noeuds d'entrée haut et bas par rapport aux circuits des figures 1 à 4. Dans ce cas, le courant de sortie Iₛ représentatif de la tension d'entrée Vₑ est un courant négatif (courant positif allant du noeud GND vers le transistor de sortie 103 ou 403 du miroir de courant). Si l'on souhaite que le circuit de mesure fournisse une tension de sortie Vₛ positive par rapport au potentiel de référence du noeud GND, on peut prévoir d'inclure une fonction d'inversion dans l'élément de conversion courant/tension 105.

Les figures 5A et 5B sont des schémas électriques partiels illustrant des exemples de réalisation d'un convertisseur courant/tension 105 incluant une fonction d'inversion.

Dans l'exemple de la figure 5A, le circuit 105 comprend un amplificateur opérationnel 501 monté en inverseur. L'amplificateur 501 comprend une borne d'alimentation basse reliée au noeud GND, et une borne d'alimentation haute recevant un potentiel d'alimentation haut V_{dd}, par exemple de l'ordre de 3 V. L'entrée non inverseuse (+) et l'entrée inverseuse (-) de l'amplificateur 501 sont respectivement reliées au noeud GND et au collecteur du transistor de sortie du miroir de courant du circuit de mesure (transistor 103/403 non visible sur la figure 5A). La sortie de l'amplificateur 501 est reliée au noeud OUT. Une boucle de contre-réaction relie la sortie de l'amplificateur 501 à l'entrée inverseuse. Dans l'exemple représenté, la boucle de contre-réaction comprend une résistance 503 identique aux résistances 104/404 (non visibles sur la figure 5A), en série avec un transistor 502 monté en diode, identique aux transistors 101/401 (non visibles sur la figure 5A). L'émetteur du transistor 502 est relié à l'entrée inverseuse de l'amplificateur 501, et la résistance 503 relie le collecteur du transistor 502 à la sortie de l'amplificateur 501. L'impédance de la boucle de contre-réaction est ainsi identique à l'impédance d'entrée du circuit de mesure différentielle. Il en résulte que, dans la plage de fonctionnement du circuit de mesure, la tension de sortie Vₛ est positive et égale à la tension d'entrée Vₑ (ou à la valeur absolue de Vₑ dans le cas du circuit de la figure 4). Des rapports d'impédance différents entre la boucle de contre-réaction et l'entrée du circuit de mesure peuvent être prévus pour obtenir des relations différentes entre la tension Vₛ et la tension Vₑ.

Dans l'exemple de la figure 5B, le circuit 105 comprend un miroir de courant 500 dont la branche d'entrée comprend un transistor PNP 505 monté en diode, et dont la branche de sortie comprend un transistor PNP 507 dont la base est reliée à la base du transistor 505. Les émetteurs des transistors 505 et 507 sont reliés à un rail d'alimentation positive V_{dd}. Le collecteur du transistor 505 est relié au collecteur du transistor de sortie du miroir de courant du circuit de mesure (transistor 103/403 non visible sur la figure 5B). Le collecteur du transistor 507 est relié au noeud OUT. Le noeud OUT est relié au noeud de référence GND par l'intermédiaire d'une résistance 508 identique aux résistances 104/404 (non visibles sur la figure 5B), en série avec un transistor 509 monté en diode, identique aux transistors 101/401 (non visibles sur la figure 5A). L'émetteur du transistor 509 est relié au noeud OUT par l'intermédiaire de la résistance 508. Le collecteur du transistor 509 est relié au noeud GND. L'impédance de la branche située entre le noeud OUT et le noeud GND est ainsi identique à l'impédance d'entrée du circuit de mesure différentielle. Dans la plage de fonctionnement du circuit de mesure, le courant Iₛ fourni par le circuit de mesure est inversé par le miroir de courant 500, et la tension de sortie Vₛ est ainsi positive et égale à la tension d'entrée Vₑ (ou à la valeur absolue de Vₑ dans le cas du circuit de la figure 4). Des rapports d'impédance différents entre le circuit de conversion 105 et l'entrée du circuit de mesure peuvent être prévus pour obtenir des relations différentes entre la tension Vₛ et la tension Vₑ.

La figure 6 est un schéma électrique représentant un exemple de réalisation d'un circuit de mesure différentielle apte à fonctionner quel que soit le signe du mode commun de la tension Vₑ à mesurer. Le circuit de la figure 6 comprend les mêmes éléments que le circuit de la figure 1, et comprend en outre, entre les noeuds d'entrée IN1 et IN2, un deuxième miroir de courant 600 et une deuxième résistance d'entrée 604, identique à la résistance 104. Le miroir de courant 600 diffère du miroir de courant 100 en ce qu'il est réalisé avec des transistors bipolaires NPN et non avec des transistors PNP. Le miroir 600 comprend, sur sa branche d'entrée, un transistor NPN 601 monté en diode, et, sur sa branche de sortie, un transistor NPN 603 dont la base est reliée à la base du transistor 601. Les émetteurs des transistors 601 et 603 sont reliés au noeud d'entrée IN1. Le collecteur du transistor 601 est relié au noeud IN2 par l'intermédiaire de la résistance 604. Le circuit de la figure 6 comprend en outre un troisième miroir de courant 700 ayant pour fonction d'inverser le courant négatif fourni en sortie du miroir 600 lorsqu'une tension Vₑ de mode commun négatif est appliquée en entrée du circuit de mesure. Le miroir 700 comprend, sur sa branche d'entrée, un transistor PNP 701 monté en diode, et, sur sa branche de sortie, un transistor PNP 703 dont la base est reliée à la base du transistor 701. Les émetteurs des transistors 701 et 703 sont reliés à un rail d'alimentation positive V_{dd}. Le collecteur du transistor 701 est relié au collecteur du transistor 603. Le collecteur du transistor 703 est relié au collecteur du transistor 103.

Lorsqu'une tension Vₑ positive (V_{b} > Vₐ) de mode commun positif est appliquée entre les bornes IN1 et IN2, le miroir de courant 100 est actif et les miroirs 600 et 700 sont inactifs (notamment parce que le transistor 603 est polarisé en inverse, ou en direct mais à une tension inférieure à son seuil de conduction). Le miroir 100 fournit un courant Iₛ₁ positif représentatif de la tension d'entrée Vₑ. Lorsqu'une tension Vₑ positive de mode commun négatif est appliquée entre les bornes IN1 et IN2, le miroir 100 est inactif et les miroirs 600 et 700 sont actifs. Le miroir 700 fournit un courant Iₛ₂ positif représentatif de la tension d'entrée Vₑ.

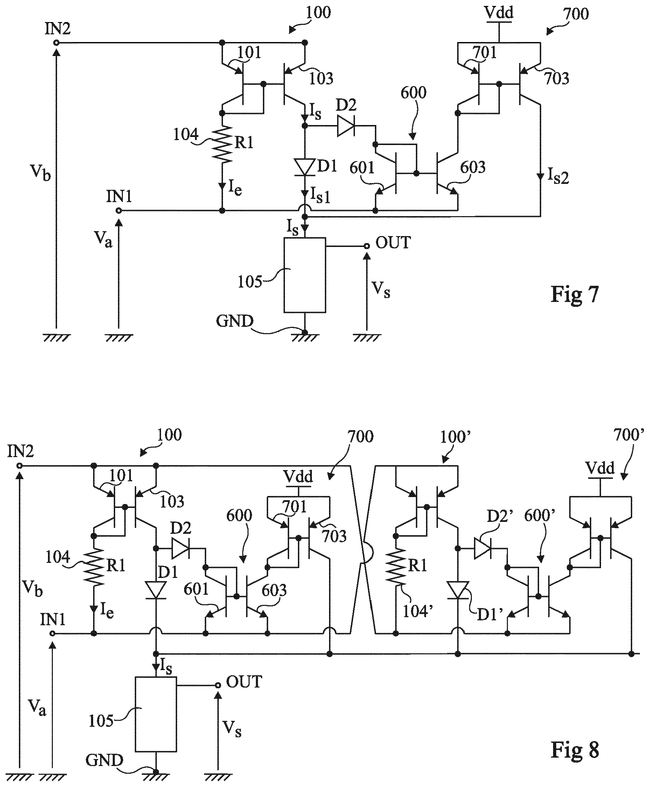

La figure 7 est un schéma électrique représentant un exemple de réalisation d'un circuit de mesure de tension différentielle apte à fonctionner quel que soit le signe du mode commun de la tension à mesurer. Le circuit de la figure 7 diffère du circuit de la figure 6 en ce que, dans le circuit de la figure 6, une résistance de valeur R1 est prévue en entrée de chacun des miroirs de courant 100 et 600 (résistances 104 et 604 respectivement), alors que dans le circuit de la figure 7, cette résistance est mutualisée. Dans le circuit de la figure 7, la résistance 604 n'est pas présente et le collecteur du transistor 601 est relié non pas à l'émetteur du transistor 103 mais à son collecteur, par l'intermédiaire d'une diode D2 dont l'anode est côté collecteur du transistor 103. De plus, une diode D1 est prévue entre le collecteur du transistor 103 et le circuit de conversion courant/tension 105, l'anode de la diode D1 étant côté collecteur du transistor 103.

La figure 8 est un schéma électrique représentant un exemple de réalisation d'un circuit de mesure de tension différentielle apte à fonctionner quel que soit le signe de la tension Vₑ à mesurer, et quel que soit le signe du mode commun de cette tension. Le circuit de la figure 8 correspond au circuit de la figure 7, dans lesquels la résistance 104, les diodes D1 et D2, et les miroirs de courant 100, 600 et 700 ont été dupliqués. La partie dupliquée, comprend une résistance 104' identique à la résistance 104, des diodes D1' et D2' respectivement identiques aux diodes D1 et D2, et des miroirs de courant 100', 600' et 700' respectivement identiques aux miroirs de courant 100, 600 et 700. Les éléments 104', D1', D2', 100', 600' et 700' sont connectés de la même façon que les éléments 104, D1, D2, 100, 600 et 700 mais en inversant les noeuds d'entrée IN1 et IN2.

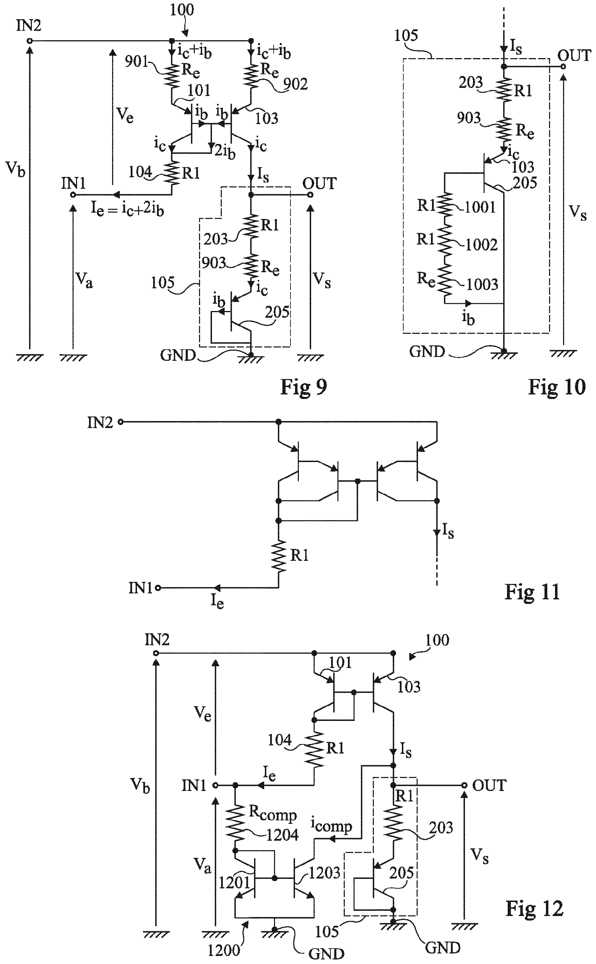

Les figures 9 à 12 sont des schémas électriques illustrant un exemple et divers modes de réalisation susceptibles d'améliorer encore le fonctionnement des circuits de mesure de tension décrits dans la présente demande.

La figure 9 illustre un mode de réalisation dans lequel des transistors du circuit de mesure différentielle sont mis en série avec des résistances d'émetteur. Dans l'exemple représenté, le circuit de mesure comprend les mêmes éléments que le circuit de la figure 1, et le convertisseur courant/tension 105 comprend les mêmes éléments que dans l'exemple de la figure 2B. Le circuit de la figure 9 comprend en outre trois résistances 901, 902 et 903 de même valeur Rₑ, connectées respectivement entre l'émetteur du transistor 101 et le noeud IN2, entre l'émetteur du transistor 103 et le noeud IN2, et en série avec la résistance 203 entre l'émetteur du transistor 205 et la résistance 203. L'ajout des résistances d'émetteur Rₑ permet de limiter l'effet de disparité entre les transistors, lié aux imprécisions de fabrication. A titre de variante, on peut prévoir de supprimer les résistances 104 et 203, et d'utiliser les résistances d'émetteur pour définir le lien entre la tension d'entrée Vₑ et le courant de sortie Iₛ du circuit de mesure. L'utilisation de résistances d'émetteur n'est bien entendu pas limitée au circuit de la figure 1 et peut être prévue dans tous les circuits de mesure décrits dans la présente demande.

La figure 10 est un schéma électrique partiel illustrant un mode de réalisation du circuit de conversion courant/tension 105 du circuit de mesure de la figure 9. Dans un miroir de courant à transistors bipolaires, un courant de base i_{b} (voir figure 9) est consommé par chacun des transistors du miroir. Or, les bases des transistors bipolaires ne sont alimentées que par la branche d'entrée (branche de gauche) du miroir. Ceci conduit à une légère asymétrie entre la branche d'entrée et la branche de sortie du miroir, ce qui se traduit par une erreur sur la grandeur de sortie Iₛ ou Vₛ du circuit de mesure. A titre d'illustration, dans le circuit de la figure 9, les courants de collecteur i_{c} des transistors 101 et 103 sont identiques. Le courant Iₛ de sortie est égal au courant i_{c}, mais le courant Iₑ d'entrée est égal à i_{c} + 2i_{b}. Les résistances d'émetteur 901 et 902 étant traversées par un courant égal à i_{c} + i_{b}, la tension différentielle d'entrée Vₑ peut s'écrire Vₑ = (Rₑ + R1)i_{c} + (Rₑ + 2R1)i_{b} + V_{be}, où V_{be} est la tension base-émetteur du transistor 101, et la tension de sortie Vₛ peut s'écrire Vₛ = (Rₑ + R1)i_{c} + Vbₑ. Il manque donc à la tension de sortie (Rₑ + 2R1)i_{b} pour être identique à la tension d'entrée. Dans le mode de réalisation de la figure 10, le circuit de conversion courant/tension 105 est adapté à compenser cette erreur. Le circuit de conversion 105 de la figure 10 comprend les mêmes éléments que le circuit de conversion 105 de la figure 9, et comprend en outre, en série entre la base et le collecteur du transistor 205, trois résistances 1001, 1002 et 1003, de valeurs respectives R1, R1 et Rₑ. Le transistor 205 étant choisi sensiblement identique aux transistors 101 et 103, son courant de base i_{b} est le même que celui des transistors 101 et 103. Le courant de base i_{b} du transistor 205 traversant les résistances 1001, 1002 et 1003, la tension de sortie Vs peut s'écrire Vₛ = (Rₑ + R1)i_{c} + V_{be} + (Rₑ + 2R1)i_{b}, et est donc égale à la tension Vₑ. La prévision d'une compensation du courant de base n'est bien entendu pas limitée au circuit de la figure 9 et peut prévue dans tous les circuits de mesure décrits dans la présente demande.

En l'absence de compensation, l'erreur liée au courant de base des transistors bipolaires est d'autant plus élevée que le gain en courant de ces transistors est faible. Pour maximiser le gain en courant, on peut prévoir, comme l'illustre la figure 11, de remplacer chacun des transistors du miroir de courant par une paire de deux transistors bipolaires du même type connectés selon un montage Darlington.

La figure 12 illustre un autre mode de réalisation du circuit de mesure de la figure 1. En théorie, dans le circuit de la figure 1, le transistor de sortie 103 du miroir de courant 100 se comporte comme une source de courant pure, et le courant de sortie Iₛ est indépendant de la tension vue par le transistor 103. Toutefois, en pratique, le courant de sortie Iₛ dérive légèrement en fonction de la tension émetteur-collecteur vue par le transistor 103. Plus cette tension est élevée, plus le courant de sortie Iₛ est important. En d'autres termes, plus le mode commun de la tension Vₑ à mesurer est élevé, plus la dérive est importante (on parle d'effet de mode commun) . Dans le mode de réalisation de la figure 12, il est prévu un élément de compensation de cet effet de mode commun. Le circuit de la figure 12 comprend les mêmes éléments que le circuit de la figure 1, et le convertisseur courant/tension 105 est le même que dans l'exemple de la figure 2B. Le circuit de la figure 12 comprend en outre un deuxième miroir de courant 1200 comprenant, sur sa branche d'entrée, un transistor bipolaire NPN 1201 monté en diode, et, sur sa branche de sortie, un transistor bipolaire NPN 1203 dont la base est reliée à la base du transistor 1201. Les émetteurs des transistors 1201 et 1203 sont reliés au noeud GND. Le collecteur du transistor 1201 est relié au noeud IN1 par l'intermédiaire d'une résistance 1204 de valeur R_{comp}. Le collecteur du transistor 1203 est relié au collecteur du transistor 103. En fonctionnement, le miroir de courant 1200 et la résistance 1204 permettent de soustraire au courant de sortie Iₛ du miroir de courant 100 un courant i_{comp} proportionnel à une tension proche de la tension vue par le transistor 103 (tension Vₐ - V_{GND} dans cet exemple). La résistance 1204 détermine la relation entre cette tension de référence et le courant i_{comp}. La valeur R_{comp} de la résistance 1204 est choisie en fonction de la sensibilité du transistor 103 à l'effet de mode commun. Cette valeur peut être déterminée par calcul ou par des mesures de caractérisation du circuit. La prévision d'une compensation de l'effet de mode commun n'est bien entendu pas limitée au circuit de la figure 1 et peut être prévue dans tous les circuits de mesure décrits dans la présente demande.

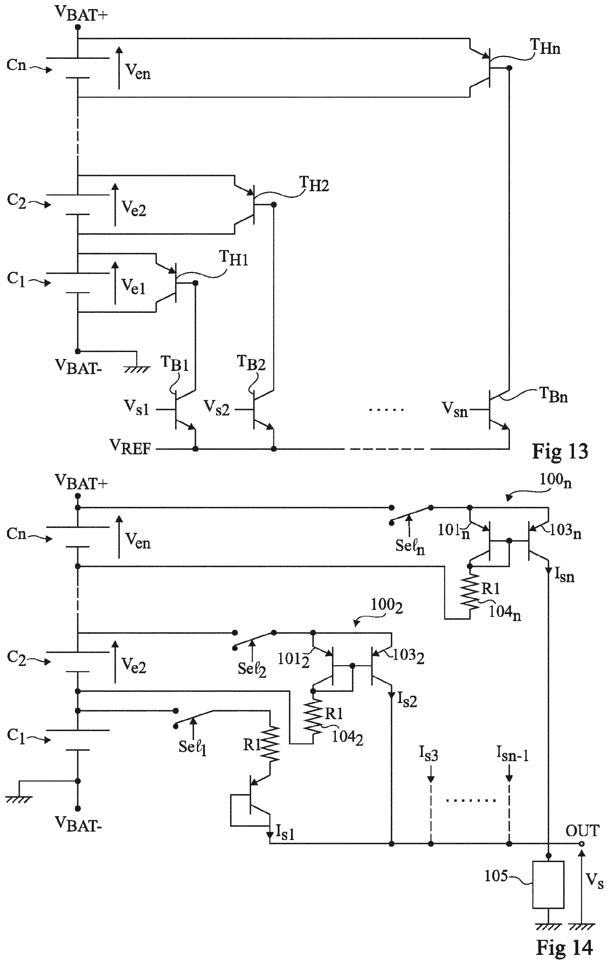

La figure 13 est un schéma électrique illustrant un exemple de réalisation d'une batterie électrique comportant une pluralité de cellules élémentaires reliées en série, et des moyens de mesure et de contrôle de la tension des cellules de la batterie. Dans l'exemple représenté, la batterie comprend n cellules élémentaires Cᵢ en série, où i est un entier allant de 1 à n, avec n entier supérieur à 1. Le noeud de potentiel bas de la première cellule C₁ de la série est relié à une borne V_{BAT-}de fourniture du potentiel bas de la batterie. Le noeud de potentiel haut de la dernière cellule Cₙ de la série est relié à une borne V_{BAT+} de fourniture du potentiel haut de la batterie. Chaque cellule Cᵢ fournit à ses bornes une tension Vₑᵢ. La tension fournie aux bornes de la batterie est égale à la somme des tensions Vₑᵢ fournies par les n cellules élémentaires.

Aux bornes de chaque cellule élémentaire Cᵢ, est connecté un circuit de mesure différentielle (non représenté) du type décrit en relation avec les figures 1 à 12, fournissant une grandeur représentative de la tension Vₑᵢ aux bornes de la batterie. Dans cet exemple, chaque circuit de mesure différentielle connecté à une cellule Cᵢ fournit une tension Vₛᵢ égale à la tension Vₑᵢ de la cellule. Dans cet exemple, le noeud de référence GND commun à tous les circuits de mesure différentielle est relié au noeud de potentiel bas V_{BAT-} de la batterie. A chaque cellule élémentaire Cᵢ, sont en outre associés un transistor bipolaire NPN T_{Bi} dont la base reçoit la tension de sortie Vₛᵢ fournie par le circuit de mesure, et un transistor bipolaire PNP T_{Hi}. L'émetteur et le collecteur du transistor T_{Hi} sont reliés respectivement au noeud de potentiel haut et au noeud de potentiel bas de la cellule Cᵢ, éventuellement par l'intermédiaire de résistances non représentées. La base du transistor T_{Hi} est reliée au collecteur du transistor T_{Bi.} Une résistance intermédiaire non représentée peut éventuellement être prévue entre la base du transistor T_{Hi} et le noeud de potentiel haut de la cellule Cᵢ. L'émetteur du transistor T_{Bi} reçoit un potentiel de référence V_{REF}.

En fonctionnement, lorsque la tension Vₛᵢ dépasse la tension V_{REF} complétée de la tension de mise en conduction du transistor T_{Bi}, le transistor T_{Bi} devient progressivement passant. Ceci conduit à rendre progressivement passant le transistor T_{Hi} et entraîne une dissipation d'énergie aux bornes de la cellule Cᵢ, ce qui permet par exemple d'éviter une surcharge des cellules de la batterie lors d'une opération de recharge de la batterie. Le seuil V_{REF} peut être fixe, ou augmenter progressivement en cours de charge de façon à équilibrer la charge de la batterie.

La figure 14 est un schéma électrique illustrant un autre exemple de réalisation d'une batterie électrique comportant une pluralité de cellules élémentaires reliées en série, et des moyens de mesure et de contrôle de la tension des cellules de la batterie. Dans l'exemple représenté, la batterie comprend n cellules élémentaires Cᵢ en série, où i est un entier allant de 1 à n, avec n entier supérieur à 1. Le noeud de potentiel bas de la première cellule C₁ de la série est relié à une borne V_{BAT-} de fourniture du potentiel bas de la batterie. Le noeud de potentiel haut de la dernière cellule Cₙ de la série est relié à une borne V_{BAT+} de fourniture du potentiel haut de la batterie. Chaque cellule Cᵢ fournit à ses bornes une tension Vₑᵢ. La tension fournie aux bornes de la batterie est égale à la somme des tensions Vₑᵢ fournies par les n cellules élémentaires.

Aux bornes de chaque cellule élémentaire Cᵢ, est connecté un circuit de mesure différentielle du type décrit en relation avec les figures 1 à 12. Dans l'exemple représenté, chaque circuit de mesure différentielle est un circuit du type décrit en relation avec la figure 1, comprenant un miroir de courant 100ᵢ à deux transistors 101ᵢ et 103ᵢ, et une résistance 104ᵢ de valeur R1 en série avec le transistor 101ᵢ. Selon un aspect de l'exemple de réalisation de la figure 14, l'élément 105 de conversion courant/tension du circuit de la figure 1 est mutualisé et partagé entre tous les circuits de mesure différentielle de la batterie. Dans cet exemple, les collecteurs des transistors 103ᵢ de tous les circuits de mesure différentielle sont reliés au même élément de conversion courant/tension 105. Un interrupteur Selᵢ est placé entre le noeud de potentiel haut de chaque cellule de la batterie et l'émetteur du transistor 101ᵢ du circuit de mesure différentielle associé à cette cellule. Des moyens de contrôle non représentés, comportant par exemple un calculateur, permettent de commander les interrupteurs Selᵢ. En fonctionnement, lorsqu'on souhaite mesurer la tension d'une cellule Cᵢ de la batterie, l'interrupteur Selᵢ associé à cette cellule est fermé, et les interrupteurs associés aux autres cellules sont ouverts. La tension Vₛ entre le noeud OUT de sortie de l'élément 105 et la masse est alors représentative de la tension aux bornes de la cellule Cᵢ.

Un avantage de l'exemple de réalisation de la figure 14 est qu'il permet de limiter le nombre d'éléments de conversion courant/tension 105. De plus, le nombre de convertisseurs analogique-numérique nécessaire pour échantillonner la tension Vₛ de sortie de l'élément 105 est également réduit.

Des modes de réalisation particuliers de la présente invention ont été décrits.

En particulier, l'invention ne se limite pas à l'utilisation particulière, décrite en relation avec la figure 13, des circuits de mesure différentielle décrits dans la présente demande. Plus généralement, l'invention ne se limite pas à une utilisation des circuits de mesure différentielle décrits dans des batteries électriques. Les circuits de mesure différentielle décrits dans la présente demande peuvent notamment être utilisés dans des applications de type générateur photovoltaïque, piles à combustibles, etc. Dans le cas d'une utilisation dans une batterie électrique, l'homme de l'art saura prévoir d'autres façons d'utiliser la grandeur Iₛ ou Vₛ fournie par le circuit de mesure différentielle pour contrôler les cellules de la batterie, que celle décrite en relation avec la figure 13. A titre d'exemple, la grandeur Iₛ ou Vₛ peut être échantillonnée et utilisée par un calculateur numérique configuré pour contrôler les cellules de la batterie. Par ailleurs, la batterie ne comporte pas nécessairement autant de circuits de mesure différentielle que de cellules élémentaires. Un multiplexeur peut être prévu pour partager un circuit de mesure différentielle ou une partie d'un circuit de mesure différentielle entre plusieurs cellules de la batterie. A titre d'exemple, un même élément de conversion courant/tension peut être partagé entre plusieurs circuits de mesure différentielle au moyen d'un multiplexeur, ce qui permet par exemple de mesurer toutes les tensions du pack batterie avec un seul convertisseur analogique numérique. De plus, pour éviter une consommation inutile d'énergie par le circuit de mesure, un interrupteur peut être prévu pour désactiver le circuit de mesure lorsqu'il n'est pas utilisé.

Par ailleurs, l'homme du métier saura réaliser tous les circuits de mesure décrits dans la présente demande en utilisant d'autres types de transistors que des transistors bipolaires, par exemple des transistors MOS, FET ou JFET. A titre d'exemple, les transistors bipolaires PNP et NPN peuvent être remplacés respectivement par des transistors MOS à canal P, et par des transistors MOS à canal N, avec les connexions de source, de grille et de drain des transistor MOS remplaçant respectivement les connexions d'émetteur, de base et de collecteur des transistors bipolaires. Les transistors MOS étant des composants bidirectionnels en courant, des diodes complémentaires peuvent, dans certains cas, être nécessaires pour assurer l'aiguillage des courants. A titre d'exemple, dans le cas particulier du circuit de la figure 4, on pourra prévoir quatre diodes supplémentaires, respectivement entre le transistor 101 et la résistance 104, l'anode de la diode étant côté transistor 101, entre le transistor 103 et le circuit 105, l'anode de la diode étant côté transistor 103, entre le transistor 401 et la résistance 404, l'anode de la diode étant côté transistor 401, et entre le transistor 403 et le circuit 105, l'anode de la diode étant côté transistor 403. Ces diodes permettent d'aiguiller le courant d'entrée dans le miroir de courant 100 lorsque la tension Vₑ est positive, et dans le miroir de courant 400 lorsque la tension Vₑ est négative.

## Revendications

1. Circuit de mesure de tension (Vₑ) comportant un premier miroir de courant (100), dans lequel :
une branche d'entrée dudit miroir (100) comprend un premier transistor (101) monté en diode, le premier transistor (101) et un premier élément résistif (104) étant connectés en série entre des premier (IN2) et second (IN1) noeuds d'application de ladite tension (Vₑ) ; et
une branche de sortie dudit miroir (100) comprend un deuxième transistor (103) fournissant un courant (Iₛ) représentatif de ladite tension (Vₑ),
le circuit comportant en outre un élément (105) de conversion dudit courant (Iₛ) en une tension (Vₛ) de sortie, l'élément de conversion (105) comprenant, en série avec la branche de sortie (103) entre le premier noeud (IN2) et un troisième noeud (GND) d'application d'un potentiel de référence, un deuxième élément résistif (203) de même valeur (R1) que le premier élément résistif (104) et troisième transistor (205) identique au premier transistor (101) du miroir de courant (100).

2. Circuit selon la revendication 1, dans lequel chaque transistor (101, 103) du miroir de courant est en série avec une résistance (901, 902).

3. Circuit selon la revendication 1 ou 2, dans lequel les transistors (101, 103) du miroir de courant sont des transistors bipolaires, ce circuit comportant en outre un circuit résistif (1001, 1002, 1003) de compensation du courant de base (i_{b}) des transistors (101, 103) du miroir de courant, entre la base et le collecteur du troisième transistor (205) .

4. Circuit selon l'une quelconque des revendications 1 à 3, comportant en outre un circuit (1200, 1204) de compensation de l'effet du mode commun sur la branche de sortie (103) du premier miroir de courant (100), ledit circuit de compensation de l'effet de mode commun comportant un deuxième miroir de courant (1201, 1203) et une résistance de compensation (1204) permettant de soustraire au courant (Is) de sortie du premier miroir de courant (100) un courant (i_{comp}) proportionnel à une tension vue par le deuxième transistor (103).

5. Batterie électrique comportant une pluralité de cellules élémentaires (Cᵢ) en série, et, aux bornes d'au moins une cellule élémentaire (Cᵢ), un circuit de mesure selon l'une quelconque des revendications 1 à 4.

6. Batterie selon la revendication 5, dans laquelle ledit circuit de mesure est utilisé pour contrôler la tension de ladite cellule (Cᵢ).

## Patentansprüche

1. Eine Spannungsmessschaltung (Vₑ) mit einem Stromspiegel (100), wobei:
ein Eingangszweig des Spiegels (100) einen ersten Transistor (101) aufweist, der als Diode geschaltet ist, wobei der erste Transistor (101) und ein erstes Widerstandselement (104) zwischen dem ersten (IN2) und dem zweiten (IN1) Knotenpunkt des Anlegens der Spannung (Vₑ) in Reihe geschaltet sind; und
ein Ausgangszweig des Spiegels (100) einen zweiten Transistor (103) aufweist, der einen für die Spannung (Vₑ) repräsentativen Strom (Iₛ) liefert,
die Schaltung außerdem ein Element (105) zur Umwandlung des Stroms (Iₛ) in eine Ausgangsspannung (Vₛ) aufweist, wobei das Umwandlungselement (105) in Reihe mit dem Ausgangszweig (103) zwischen dem ersten Knoten (IN2) und einem dritten Knoten (GND) zum Anlegen eines Bezugspotentials ein zweites Widerstandselement (203) mit demselben Wert (R1) wie das erste Widerstandselement (104) und einen dritten Transistor (205) aufweist, der mit dem ersten Transistor (101) des Stromspiegels (100) identisch ist.

2. Schaltung nach Anspruch 1, wobei jeder Transistor (101, 103) des Stromspiegels mit einem Widerstand (901, 902) in Reihe geschaltet ist.

3. Schaltung nach Anspruch 1 oder 2, wobei die Transistoren (101, 103) des Stromspiegels bipolare Transistoren sind, wobei diese Schaltung ferner eine Widerstandsschaltung (1001, 1002, 1003) zur Kompensation des Basisstroms (i_{b}) der Transistoren (101, 103) des Stromspiegels zwischen der Basis und dem Kollektor des dritten Transistors (205) aufweist.

4. Schaltung nach einem der Ansprüche 1 bis 3, die ferner eine Schaltung (1200, 1204) zum Kompensieren des Gleichtakteffekts am Ausgangszweig (103) des ersten Stromspiegels (100) aufweist, wobei die Schaltung zum Kompensieren des Gleichtakteffekts einen zweiten Stromspiegel (1201, 1203) und einen Kompensationswiderstand (1204) aufweist, der so konfiguriert ist, dass er von dem Ausgangsstrom (Is) des ersten Stromspiegels (100) einen Strom (i_{comp}) subtrahiert, der proportional zu einer Spannung an dem zweiten Transistor (103) ist.

5. Eine elektrische Batterie mit einer Vielzahl von in Reihe geschalteten Elementarzellen (Cᵢ) und, über mindestens einer Elementarzelle (Cᵢ), der Messschaltung nach einem der Ansprüche 1 bis 4.

6. Batterie nach Anspruch 5, wobei die Messschaltung zur Steuerung der Spannung der Zelle (Cᵢ) verwendet wird.

## Claims

1. A voltage measurement circuit (Vₑ) comprising a current mirror (100), wherein:
an input branch of said mirror (100) comprises a first transistor (101) diode mounted, the first transistor (101) and a first resistive element (104) being series-connected between first (IN2) and second (IN1) nodes of application of said voltage (Vₑ); and
an output branch of said mirror (100) comprises a second transistor (103) providing a current (Iₛ) representative of said voltage (Vₑ),
the circuit further comprising an element (105) for converting said current (Iₛ) into an output voltage (Vₛ), the conversion element (105) comprising, in series with the output branch (103) between the first node (IN2) and a third node (GND) for applying a reference potential, a second resistive element (203) of same value (R1) as the first resistive element (104) and a third transistor (205) identical to the first transistor (101) of the current mirror (100).

2. The circuit of claim 1, wherein each transistor (101, 103) of the current mirror is series-connected with a resistor (901, 902) .

3. The circuit of claim 1 or 2, wherein the transistors (101, 103) of the current mirror are bipolar transistors, this circuit further comprising a resistive circuit (1001, 1002, 1003) for compensating the base current (i_{b}) of the transistors (101, 103) of the current mirror, between the base and the collector of the third transistor (205).

4. The circuit of any of claims 1 to 3, further comprising a circuit (1200, 1204) for compensating the common-mode effect on the output branch (103) of the first current mirror (100), said circuit for compensating the common-mode effect comprising a second current mirror (1201, 1203) and a compensation resistance (1204) configured to subtract from the output current (Is) of the first current mirror (100) a current (i_{comp}) proportional to a voltage across the second transistor (103).

5. An electric battery comprising a plurality of series-connected elementary cells (Cᵢ) and, across at least one elementary cell (Cᵢ), the measurement circuit of any of claims 1 to 4.

6. The battery of claim 5, wherein said measurement circuit is used to control the voltage of said cell (Cᵢ).
